# EUROPEAN PATENT APPLICATION

(11) **EP 4 474 838 A1**
(43) Date of publication of application: **11.12.2024**
(21) Application number: 23812155.2
(22) Date of filing: 24.05.2023
(51) Int. Cl.: G01R 31/367, G01R 31/392, G01R 31/3842, G01R 19/165, G01R 19/00

(54) **APPARATUS AND METHOD FOR DIAGNOSING BATTERY**

(30) Priority: 26.05.2022 KR 20220064999
(71) Applicant: LG Energy Solution, Ltd., Seoul 07335 (KR)
(72) Inventor: KWON, Gyeong-Min, Daejeon 34122 (KR); CHOI, Ho-Deuk, Daejeon 34122 (KR)
(74) Representative: Plasseraud IP
(86) International application number: PCT/KR2023/007101
(87) International publication number: WO 2023/229381

(57) **Abstract**

An apparatus for diagnosing a battery according to an embodiment of the present disclosure includes a prerequisite judging unit configured to determine a prerequisite preset to correspond to a diagnostic content for a battery, obtain prerequisite information corresponding to the prerequisite from an external device, and determine whether the prerequisite is satisfied based on the obtained prerequisite information; and a state diagnosing unit configured to obtain battery information corresponding to the diagnostic content and diagnose the state of the battery based on the diagnostic content and the battery information depending on whether the prerequisite is satisfied.

## Description

### TECHNICAL FIELD

The present application claims priority to Korean Patent Application No. 10-2022-0064999 filed on May 26, 2022 in the Republic of Korea, the disclosures of which are incorporated herein by reference.

The present disclosure relates to an apparatus and method for diagnosing a battery, and more particularly, to an apparatus and method for diagnosing a battery, which is capable of diagnosing a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

When such a battery is installed in a driving device of a vehicle or ESS (Energy storage system), the BMS (Battery management system) diagnoses the state of the battery and generates and outputs a DTC (Diagnostic trouble code) for the diagnosis result. Since the DTC is indicated in the diagnosis result for the battery, the state of the battery at the time of diagnosis can be confirmed through the DTC.

In general, the BMS can first check whether diagnosis can be performed before diagnosing the state of the battery. Specifically, the BMS can check preset prerequisites for each diagnostic content and diagnose the state of the battery for that diagnostic content only when all prerequisites are satisfied. The reason why the BMS checks the prerequisites first is because if the prerequisites are not satisfied, the diagnosis result may be inaccurate even if the state of the battery is diagnosed. Therefore, the BMS is designed to diagnose the state of the battery for the relevant diagnostic content when all prerequisites are satisfied.

However, when there are multiple prerequisites for a certain diagnostic content, if even one prerequisite is not satisfied, the state of the battery may not be diagnosed for the diagnostic content. Because of this, since DTC for the diagnostic content is not generated, a problem arises in which both the reason why the diagnosis is not performed for the diagnostic content and the battery state cannot be confirmed.

### DISCLOSURE

### Technical Problem

The present disclosure is designed to solve the problems of the related art, and therefore the present disclosure is directed to providing an apparatus and method for diagnosing a battery, which may diagnose the state of a battery depending on whether prerequisites are satisfied, and if the prerequisites are not satisfied, record the reason for dissatisfaction with the prerequisites and predictively diagnose the state of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a prerequisite judging unit configured to determine a prerequisite preset to correspond to a diagnostic content for a battery, obtain prerequisite information corresponding to the prerequisite from an external device, and determine whether the prerequisite is satisfied based on the obtained prerequisite information; and a state diagnosing unit configured to obtain battery information corresponding to the diagnostic content and diagnose the state of the battery based on the diagnostic content and the battery information depending on whether the prerequisite is satisfied.

When the prerequisite is satisfied, the state diagnosing unit may be configured to diagnose the state of the battery by comparing the battery information corresponding to the diagnostic content with the diagnostic content.

When the prerequisite is not satisfied, the state diagnosing unit may be configured to assume that the prerequisite is satisfied and diagnose an expected state of the battery by comparing the battery information corresponding to the diagnostic content with the diagnostic content.

When the prerequisite is plural, the state diagnosing unit may be configured to diagnose an expected state of the battery if any one of the plurality of prerequisites is not satisfied.

An apparatus for diagnosing a battery according to another the present disclosure may further comprise a storage unit configured to store at least one diagnostic content for the state of the battery and at least one prerequisite corresponding to the diagnostic content.

The state diagnosing unit may be configured to store the diagnosis result for the battery, a diagnosis type indicating the state of the battery, and whether the prerequisite is satisfied in the storage unit.

The state diagnosing unit may be configured to determine a DTC flag indicating the diagnosis result for the battery, a diagnosis type flag indicating the diagnosis type, and a prerequisite flag indicating whether the prerequisite is satisfied, and map and store the DTC flag, the diagnosis type flag, and the prerequisite flag in the storage unit.

When the prerequisite is plural, the state diagnosing unit may be configured to determine the prerequisite flag for each of the plurality of prerequisites.

A battery pack according to still another aspect of the present disclosure may comprise the apparatus for diagnosing a battery according to one aspect of the present disclosure.

A vehicle according to still another aspect of the present disclosure may comprise the apparatus for diagnosing a battery according to one aspect of the present disclosure.

A method for diagnosing a battery according to still another aspect of the present disclosure may comprise a prerequisite determining step of determining a prerequisite preset to correspond to a diagnostic content for a battery; a prerequisite information obtaining step of obtaining prerequisite information corresponding to the prerequisite from an external device; a prerequisite satisfaction determining step of determining whether the prerequisite is satisfied based on the obtained prerequisite information; a battery information obtaining step of obtaining battery information corresponding to the diagnostic content; and a battery state diagnosing step of diagnosing the state of the battery based on the diagnostic content and the battery information depending on whether the prerequisite is satisfied.

### Advantageous Effects

According to one aspect of the present disclosure, the state of the battery can be diagnosed after first determining whether the prerequisites are met. Therefore, the accuracy and reliability of the battery state diagnosis result can be improved.

Additionally, according to one aspect of the present disclosure, there is an advantage that the expected state of the battery can be diagnosed even when at least one of the prerequisites is not satisfied.

In addition, according to one aspect of the present disclosure, the diagnosis result, diagnosis type, and whether prerequisites are satisfied are mapped and stored, so there is an advantage in providing various information about the state diagnosis of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a diagram schematically showing the apparatus for diagnosing a battery according to an embodiment of the present disclosure and an external device.
FIG. 3 is a diagram schematically showing a list of prerequisites referred to by the apparatus for diagnosing a battery according to an embodiment of the present disclosure.
FIG. 4 is a diagram showing an example of the list of prerequisites according to an embodiment of the present disclosure.
FIG. 5 is a diagram schematically showing mapping information stored in the apparatus for diagnosing a battery according to an embodiment of the present disclosure.
FIG. 6 is a diagram showing an example of the mapping information according to an embodiment of the present disclosure.
FIG. 7 is a diagram schematically showing an exemplary configuration of a battery pack according to another embodiment of the present disclosure.
FIG. 8 is a diagram schematically showing a vehicle according to still another embodiment of the present disclosure.
FIG. 9 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, the present disclosure will be described in detail with reference to the accompanying drawings.

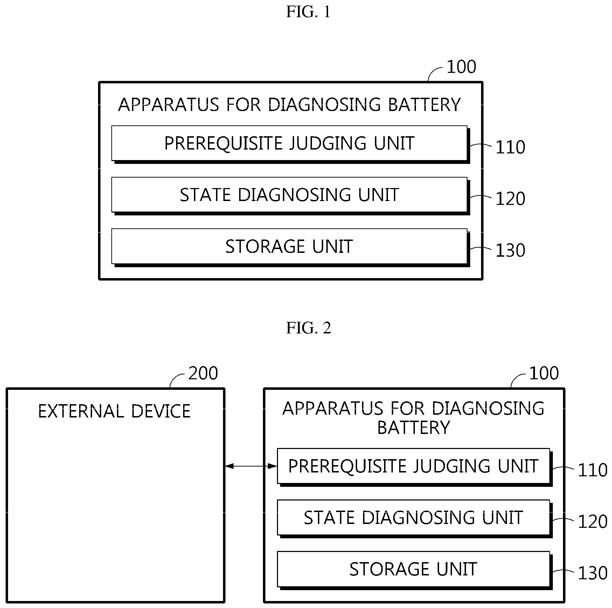

FIG. 1 is a diagram schematically illustrating an apparatus 100 for diagnosing a battery according to an embodiment of the present disclosure. FIG. 2 is a diagram schematically showing the apparatus 100 for diagnosing a battery according to an embodiment of the present disclosure and an external device 200.

Referring to FIG. 1, the apparatus 100 for diagnosing a battery according to an embodiment of the present disclosure may include a prerequisite judging unit 110 and a state diagnosing unit 120.

The prerequisite judging unit 110 may be configured to determine a prerequisite preset to correspond to a diagnostic content for a battery.

Specifically, the prerequisite judging unit 110 may receive a diagnostic content for the battery first. Preferably, the prerequisite judging unit 110 may receive a diagnostic content about the battery from an external device 200. In the embodiment of FIG. 2, the prerequisite judging unit 110 may be connected to the external device 200 to communicate wired and/or wirelessly. The external device 200 is a device for diagnosing the state of the battery, and for example, may be a device or a server that can test the battery.

Specifically, the diagnostic content may be a content that compares the state of the battery with a predetermined value. For example, the diagnostic content may include a comparison content as to whether the temperature of the battery is below a predetermined temperature value or whether the voltage of the battery is above a predetermined voltage value. As a specific example, the diagnostic content may include information about "whether the temperature of the battery is below -30°C."

At least one prerequisite corresponding to the diagnostic content can be stored in advance in the form of a list of prerequisites. Specifically, prerequisites corresponding to diagnostic target factors among the diagnostic content may be stored in advance in the form of a list of prerequisites.

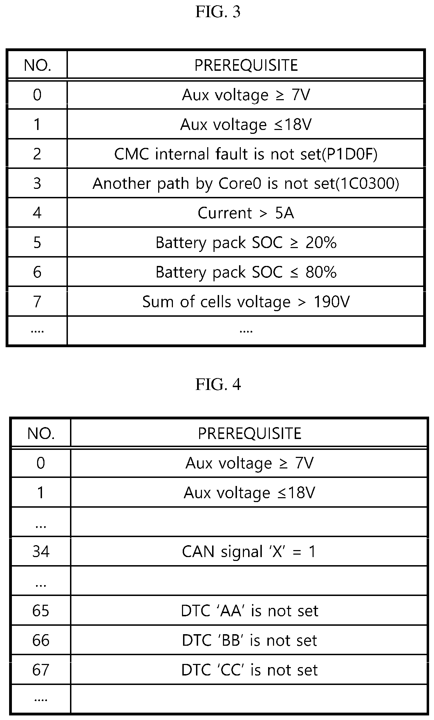

FIG. 3 is a diagram schematically showing a list of prerequisites referred to by the apparatus 100 for diagnosing a battery according to an embodiment of the present disclosure. Referring to FIG. 3, the list of prerequisites starts from record 0, and each record may include a predetermined prerequisite.

The prerequisite judging unit 110 may determine the prerequisite corresponding to the diagnostic content for the battery by referring to the list of prerequisites. As in the previous embodiment, it is assumed that the diagnostic content is "whether the temperature of the battery is below -30°C." The diagnostic target factor included in the diagnostic content is "temperature". Therefore, the prerequisite judging unit 110 can determine at least one prerequisite corresponding to the "temperature" in the list of prerequisites.

FIG. 4 is a diagram showing an example of the list of prerequisites according to an embodiment of the present disclosure. Specifically, FIG. 4 is a diagram showing only the prerequisites corresponding to the previously described diagnostic content ("whether the temperature of the battery is below -30°C"). The prerequisite judging unit 110 may determine a first prerequisite for whether the voltage of the auxiliary battery (Aux battery) is 7 V or higher, a second prerequisite for whether the voltage of the auxiliary battery is 18 V or lower, a third prerequisite for whether the CAN (Controller area network) signal 'X' is 1, a fourth prerequisite for whether DTC (Diagnostic trouble code) 'AA' is not set, a fifth prerequisite for whether DTC `BB' is not set, and a sixth prerequisite for whether DTC 'CC' is not set.

The prerequisite judging unit 110 may be configured to obtain prerequisite information corresponding to the prerequisite from the external device 200.

Specifically, the prerequisite judging unit 110 may obtain prerequisite information from the external device 200 to verify the determined prerequisite.

For example, it is assumed that the first to sixth prerequisites of the previous embodiment have been determined. The prerequisite judging unit 110 can obtain the voltage of the auxiliary battery, the value of CAN signal 'X', whether DTC 'AA' is set, whether DTC 'BB' is set, and whether DTC 'CC' is set from the external device 200.

The prerequisite judging unit 110 may be configured to determine whether the prerequisite is satisfied based on the obtained prerequisite information.

Specifically, the prerequisite judging unit 110 may determine whether the prerequisite corresponding to the diagnostic content is satisfied by substituting the obtained prerequisite information into the corresponding prerequisite. Here, the state of the battery can be diagnosed as normal only if the prerequisite is satisfied. In other words, the state of the battery according to the diagnostic content can be diagnosed as normal when all prerequisites corresponding to the diagnostic content are satisfied.

For example, in the previous embodiment, it is assumed that the prerequisite information received by the prerequisite judging unit 110 is as follows.
1) Voltage of auxiliary battery: 7 V
2) Value of CAN signal 'X': 1
3) Whether DTC 'AA' is set: Not set
4) Whether DTC 'BB' is set: Not set
5) Whether DTC 'CC' is set: Not set

Referring to FIG. 4, since the voltage of the auxiliary battery is 7 V, the first prerequisite and the second prerequisite can be satisfied. Additionally, since the value of CAN signal 'X' is 1, the third prerequisite can also be satisfied. Additionally, since DTCs `AA', `BB', and 'CC' are not all set, the fourth to sixth prerequisites can also be satisfied. Therefore, the prerequisite judging unit 110 may determine that all prerequisites corresponding to the diagnostic content are satisfied.

The state diagnosing unit 120 may be configured to obtain battery information corresponding to the diagnostic content.

Specifically, the state diagnosing unit 120 may be configured to obtain battery information corresponding to the diagnostic content as well as voltage, current, temperature, and SOC of the battery. Preferably, the state diagnosing unit 120 can obtain information about a diagnostic target factor included in the diagnostic content.

For example, the state diagnosing unit 120 may obtain battery information corresponding to the diagnostic content from a measurement unit that measures the state of the battery or a storage unit that stores state information of the battery. As another example, the state diagnosing unit 120 may obtain battery information required for battery state diagnosis from an external server, etc.

For example, as in the previous embodiment, it is assumed that the diagnostic content is "whether the temperature of the battery is less than -30°C." The state diagnosing unit 120 can obtain current temperature information of the battery as the battery information.

The state diagnosing unit 120 may be configured to diagnose the state of the battery based on the diagnostic content and the battery information depending on whether the prerequisite is satisfied.

Specifically, the state diagnosing unit 120 may diagnose the state of the battery by substituting the obtained battery information into the diagnostic content. Preferably, the battery state can be determined in advance to correspond to whether the diagnostic content is satisfied. For example, if the battery information satisfies the diagnostic content, the battery state may be normal, and if the battery information does not satisfy the diagnostic content, the battery state may be abnormal. Conversely, if the battery information satisfies the diagnostic content, the battery state may be abnormal, and if the battery information does not satisfy the diagnostic content, the battery state may be normal. That is, the battery state regarding whether the diagnostic content is satisfied may be set in advance based on the correspondence relationship between the diagnostic target factor and a comparison value, or may be set during the process of generating the diagnostic content.

As in the previous embodiment, it is assumed that the diagnostic content is "whether the temperature of the battery is below -30°C". If the diagnostic content is satisfied, the battery temperature is below -30°C, so the battery state can be diagnosed as abnormal. Conversely, if the diagnostic content is not satisfied, the battery temperature is over -30°C, so the battery state can be diagnosed as normal.

The apparatus 100 for diagnosing a battery according to an embodiment of the present disclosure is characterized by first determining whether prerequisite for diagnosing the battery state is satisfied, rather than directly diagnosing the state of the battery based on the battery information. Therefore, the apparatus 100 for diagnosing a battery has an advantage of more accurately diagnosing the state of the battery corresponding to the diagnostic content because it takes more into account whether the prerequisite is satisfied.

Meanwhile, the prerequisite judging unit 110 and the state diagnosing unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the prerequisite judging unit 110 and the state diagnosing unit 120 may be implemented as a set of program modules. At this time, the program module may be stored in the memory and executed by the prerequisite judging unit 110 and the state diagnosing unit 120. The memory may be inside or outside the prerequisite judging unit 110 and the state diagnosing unit 120 and may be connected to the prerequisite judging unit 110 and the state diagnosing unit 120 by various well-known means.

Specifically, the state diagnosing unit 120 may be configured to diagnose the state of the battery by comparing the diagnostic content with the battery information corresponding to the diagnostic content when the prerequisite is satisfied.

For example, when there is a plurality of prerequisites, the state diagnosing unit 120 can diagnose the state of the battery by comparing the battery information and the diagnostic content when all of the plurality of prerequisites are satisfied.

Preferably, at least one prerequisite corresponding to the diagnostic content may be a prerequisite that must first be satisfied in order to diagnose the state of the battery according to the diagnostic content.

For example, if the prerequisite is not satisfied, even if the state of the battery is diagnosed according to the diagnostic content, it cannot be certain that the diagnosis result accurately reflects the current state of the battery. Therefore, when the prerequisite is satisfied, the state diagnosing unit 120 can diagnose the state of the battery by substituting the battery information into the diagnostic content.

In the previous embodiment, it is assumed that the first to sixth prerequisites are all satisfied, the diagnostic content is "whether the temperature of the battery is less than -30°C", and the obtained battery information is -40°C. The state diagnosing unit 120 may substitute the battery information (-40°C) into the diagnostic content (whether the temperature of the battery is less than -30°C) and determine that the battery information satisfies the diagnostic content. Additionally, the state diagnosing unit 120 can diagnose the state of the battery as an abnormal state.

In this embodiment, because the diagnostic content is "whether the temperature of the battery is less than -30°C", the battery information satisfies the diagnostic content, but the state of the battery may be diagnosed as abnormal. On the other hand, if the diagnostic content is "whether the temperature of the battery is -30°C or higher", the state of the battery may be diagnosed as abnormal because the battery information does not satisfy the diagnostic content. In other words, whether the diagnostic content is satisfied and the state of the battery being diagnosed may vary depending on the diagnostic content.

The apparatus 100 for diagnosing a battery according to an embodiment of the present disclosure has an advantage that the diagnosis result is accurate and highly reliable because it diagnoses the state of the battery when all prerequisites are satisfied.

Meanwhile, when the prerequisite is not satisfied, the state diagnosing unit 120 may be configured to assume that the prerequisite is satisfied and diagnose the expected state of the battery by comparing the battery information corresponding to the diagnostic content with the diagnostic content.

For example, when there is a plurality of prerequisites, the state diagnosing unit 120 may be configured to diagnose the expected state of the battery if any one of the plurality of prerequisites is not satisfied.

Here, the expected state of the battery may be temporary state information about the battery diagnosed according to the obtained battery information and the diagnostic content. In other words, the expected state of the battery may be state information of the battery that can be diagnosed only when the prerequisite is not satisfied. Because the prerequisite is not satisfied, the accuracy of the diagnosis result may be low compared to the previous battery state.

However, if it is strictly considered whether the prerequisite of the battery is satisfied, a problem may occur in which the state of the battery is not diagnosed due to dissatisfaction of the prerequisite. Accordingly, the state diagnosing unit 120 can diagnose the state of the battery as normal when the prerequisite is satisfied, and can temporarily diagnose the state of the battery even when the prerequisite is not satisfied.

For example, it is assumed that the first to sixth prerequisites are the same as those in the embodiment of FIG. 4, and the prerequisites obtained by the prerequisite judging unit 110 are as follows.
1) Voltage of auxiliary battery: 7 V
2) Value of CAN signal 'X': 2
3) Whether DTC `AA' is set: Set
4) Whether DTC 'BB' is set: Not set
5) Whether DTC 'CC' is set: Not set

Referring to FIG. 4, since the voltage of the auxiliary battery is 7 V, the first prerequisite and the second prerequisite can be satisfied. However, since the value of CAN signal 'X' is 2, the third prerequisite may not be satisfied. Additionally, because DTC 'AA' is set, the fourth prerequisite cannot be satisfied. Since both DTCs 'BB' and 'CC' are not set, the fifth and sixth prerequisites can be satisfied. Accordingly, the prerequisite judging unit 110 may judge that the third and fourth prerequisites among the first to sixth prerequisites corresponding to the diagnostic content are not satisfied. The state diagnosing unit 120 cannot diagnose the state of the battery because the third and fourth prerequisites are not satisfied. However, the state diagnosing unit 120 assumes that the third and fourth prerequisites are satisfied and can diagnose the expected state of the battery by substituting the battery information into the diagnostic content.

In other words, the apparatus 100 for diagnosing a battery according to an embodiment of the present disclosure can diagnose the state of the battery based on the battery information when all prerequisites are satisfied. In addition, the apparatus 100 for diagnosing a battery can diagnose the expected state of the battery assuming that all prerequisites are satisfied, in order to solve the problem that the state of the battery is not diagnosed because some of the prerequisites are unsatisfied. However, even if the expected state of the battery is diagnosed, the same follow-up measures may not be taken as when the state of the battery is diagnosed because the prerequisites are not satisfied.

Referring to FIG. 1, the apparatus 100 for diagnosing a battery may further include a storage unit 130.

The storage unit 130 may be configured to store at least one diagnostic content for the state of the battery and at least one prerequisite corresponding to the diagnostic content.

Here, the storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by each component of the apparatus 100 for diagnosing a battery are defined.

Specifically, the storage unit 130 may store at least one prerequisite corresponding to the diagnostic content in advance in the form of a list of prerequisites. Preferably, the storage unit 130 may store prerequisites corresponding to diagnostic target factors among the diagnostic content in advance in the form of a list of prerequisites. For example, the list of prerequisites according to the embodiments of FIGS. 3 and 4 may be stored in advance in the storage unit 130.

The state diagnosing unit 120 may be configured to store the diagnosis result for the battery, a diagnosis type indicating the state of the battery, and whether prerequisites are satisfied in the storage unit 130.

Specifically, the state diagnosing unit 120 may map and store the diagnosis result, the diagnosis type, and the satisfaction of prerequisites in the storage unit 130.

Here, the diagnosis result relates to the diagnosed state of the battery and can indicate normal or abnormal. The diagnosis type relates to the diagnosed content and can indicate the state of the battery or the expected state of the battery. In other words, the diagnosis type may indicate whether the result diagnosed by the state diagnosing unit 120 is related to the state of the battery or the expected state of the battery. The prerequisite satisfaction refers to whether at least one prerequisite corresponding to the diagnostic content is satisfied, and can indicate satisfaction or dissatisfaction.

According to an embodiment of the present disclosure, since the diagnosis result, the diagnosis type, and whether prerequisites are satisfied are mapped and stored for the diagnostic content, there is an advantage in that the overall diagnosis status can be easily checked.

The state diagnosing unit 120 may be configured to determine a DTC flag indicating the diagnosis result for the battery, a diagnosis type flag indicating the diagnosis type, and a prerequisite flag indicating whether the prerequisites are satisfied.

Specifically, the state diagnosing unit 120 may be configured to map the DTC flag, the diagnosis type flag, and the prerequisite flag and store them in the storage unit 130.

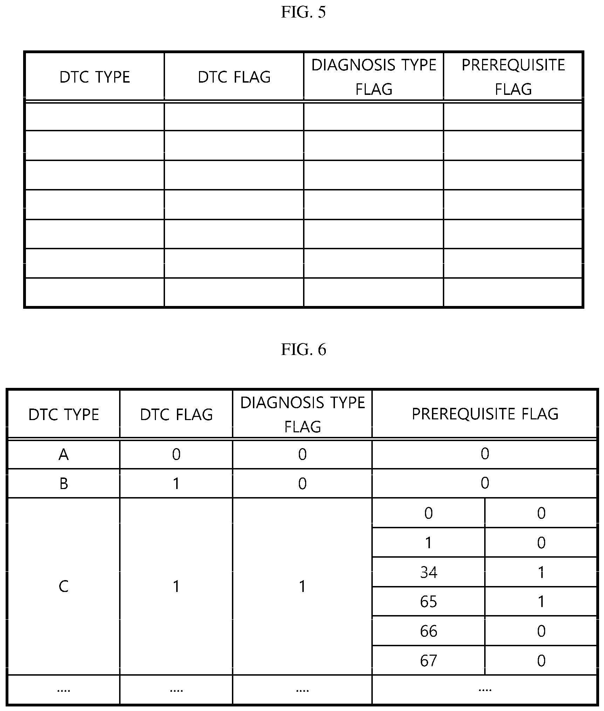

FIG. 5 is a diagram schematically showing mapping information stored in the apparatus 100 for diagnosing a battery according to an embodiment of the present disclosure.

In the embodiment of FIG. 5, the mapping information may include a DTC type, a DTC flag, a diagnosis type flag, and a prerequisite flag.

The DTC type is a value related to the type of DTC, and a preset value regarding the type of DTC to be diagnosed may be recorded.

The DTC flag is a value related to the diagnosis result, and whether the state of the battery is normal or abnormal may be recorded. For example, if the battery state is normal, '0' may be recorded, and if it is abnormal, '1' may be recorded.

The diagnosis type flag is a value related to the diagnosis type, and whether the diagnosis result of the state diagnosing unit 120 is the state of the battery or the expected state of the battery may be recorded. For example, if the diagnosis result is related to the state of the battery, '0' may be recorded, and if the diagnosis result is related to the expected state of the battery, '1' may be recorded.

The prerequisite flag relates to whether at least one prerequisite corresponding to the diagnostic content is satisfied, and whether each prerequisite is satisfied can be recorded. For example, if the prerequisite is satisfied, '0' may be recorded, and if it is not satisfied, '1' may be recorded.

When there is a plurality of prerequisites, the state diagnosing unit 120 may be configured to determine a prerequisite flag for each of the plurality of prerequisites.

FIG. 6 is a diagram showing an example of the mapping information according to an embodiment of the present disclosure. Specifically, in the embodiment of FIG. 6, diagnosis regarding DTC A, DTC B, and DTC C may have been performed.

First, the mapping information regarding DTC A may be stored in record 601. Since the DTC flag is `0', it can be seen that the battery has been diagnosed as in a normal state. Since the diagnosis type flag is '0', it can be seen that the state of the battery has been diagnosed. Since the prerequisite flag is `0', it can be seen that at least one prerequisite corresponding to DTC A is all satisfied at the time of diagnosis.

Next, the mapping information regarding DTC B may be stored in record 602. Since the DTC flag is '1', it can be seen that the battery has been diagnosed as in an abnormal state. Since the diagnosis type flag is '0', it can be seen that the state of the battery has been diagnosed. Since the prerequisite flag is `0', it can be seen that at least one prerequisite corresponding to DTC B is all satisfied at the time of diagnosis.

Lastly, the mapping information regarding DTC C may be stored in record 603. Since the DTC flag is '1', it can be seen that the battery has been diagnosed as in an abnormal state. Since the diagnosis type flag is '1', it can be seen that the expected state of the battery has been diagnosed. The first prerequisite to the sixth prerequisite may be the prerequisites shown in FIG. 4. The prerequisite flags for the first prerequisite, the second prerequisite, the fifth prerequisite, and the sixth prerequisite are '0', so it can be seen that the corresponding prerequisites have been satisfied. However, since the prerequisite flags for the third prerequisite and the fourth prerequisite are '1', it can be seen that the corresponding prerequisites are unsatisfied. Therefore, the diagnosis type flag for DTC C may be '1'.

The apparatus 100 for diagnosing a battery has an advantage of allowing details about the battery state diagnosis result to be easily checked by storing specific mapping information about the battery state diagnosis result. In other words, if a prerequisite is unsatisfied, it can be easily confirmed through mapping information which prerequisite is unsatisfied at the time of diagnosis.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the prerequisite judging unit 110, the state diagnosing unit 120 and the storage unit 130 of the apparatus 100 for diagnosing a battery may be implemented as components of the BMS.

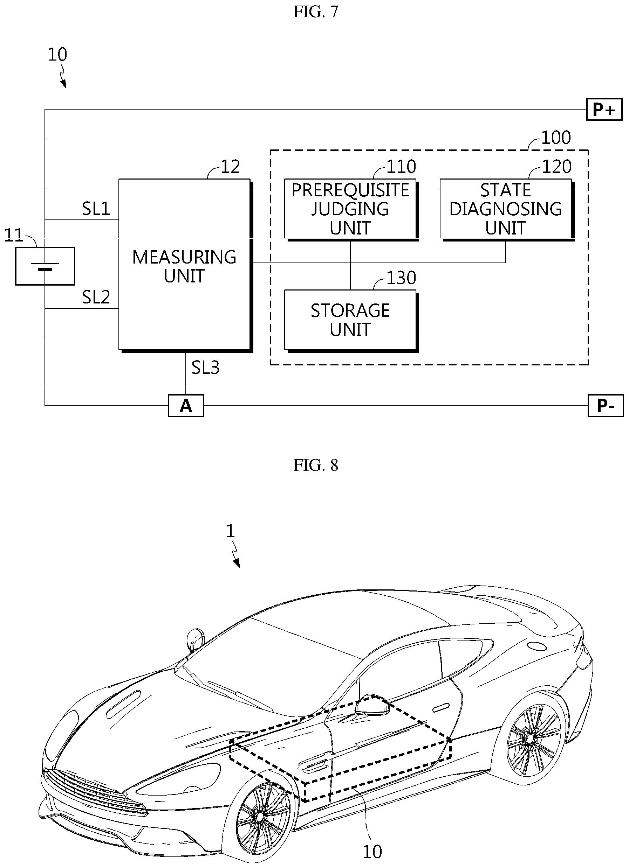

FIG. 7 is a diagram schematically showing an exemplary configuration of a battery pack according to another embodiment of the present disclosure.

Additionally, the apparatus 100 for diagnosing a battery according to the present disclosure may be provided in the battery pack 10. That is, the battery pack 10 according to the present disclosure may include the above-described apparatus 100 for diagnosing a battery and at least one battery cell. Additionally, the battery pack 10 may further include electrical components (relays, fuses, etc.) and a case.

FIG. 7 is a diagram showing an exemplary configuration of the battery pack 10 including the apparatus 100 for diagnosing a battery according to an embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2 and the third sensing line SL3. Specifically, the measuring unit 12 may be connected to the positive electrode terminal of the battery 11 through the first sensing line SL1, and may be connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to a current measurement unit A through the third sensing line SL3. For example, the current measurement unit A may be an ammeter or shunt resistor that can measure the charging current and discharging current of the battery 11. The measuring unit 12 may calculate the charging amount by measuring the charging current of the battery 11 through the third sensing line SL3. Additionally, the measuring unit 12 may calculate the discharge amount by measuring the discharge current of the battery 11 through the third sensing line SL3.

The measuring unit 12 is connected to the apparatus 100 for diagnosing a battery, and the battery information measured by the measuring unit 12 may be stored in the storage unit 130. Additionally, the battery information measured by the measuring unit 12 may be used in the process of diagnosing the state of the battery in the state diagnosing unit 120.

The positive electrode terminal P+ and the negative electrode terminal P- of the battery pack 10 may be connected to a load or charging device.

FIG. 8 is a diagram schematically showing a vehicle 1 according to still another embodiment of the present disclosure.

Referring to FIG. 8, the battery pack 10 according to an embodiment of the present disclosure may be included in a vehicle 1 such as an electric vehicle (EV) or a hybrid vehicle (HV). In addition, the battery pack 10 may drive the vehicle 1 by supplying power to a motor through an inverter included in the vehicle 1.

Preferably, the apparatus 100 for diagnosing a battery may be included in the battery pack 10, and the battery pack 10 may be included in the vehicle 1.

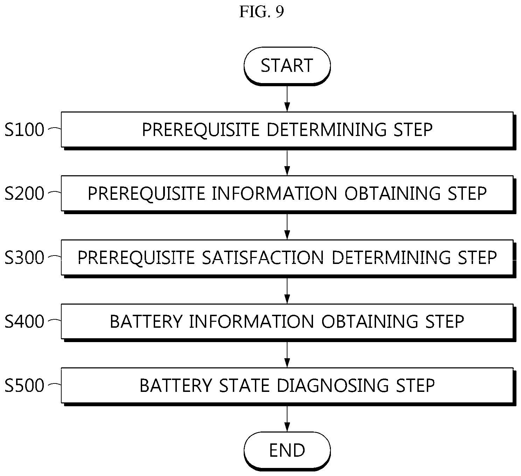

FIG. 9 is a diagram schematically showing a method for diagnosing a battery according to still another embodiment of the present disclosure.

Each step of the method for diagnosing a battery may be performed by the apparatus 100 for diagnosing a battery. Hereinafter, for convenience of explanation, it should be noted that the content overlapping with the previously described content will be briefly described or omitted.

Referring to FIG. 9, the method for diagnosing a battery may include a prerequisite determining step (S100), a prerequisite information obtaining step (S200), a prerequisite satisfaction determining step (S300), a battery information obtaining step (S400), and a battery state diagnosing step (S500).

The prerequisite determining step (S100) is a step of determining a prerequisite preset to correspond to a diagnostic content for a battery, and may be performed by the prerequisite judging unit 110.

For example, the prerequisite judging unit 110 may be configured to determine a prerequisite that is preset to correspond to the diagnostic content for the battery. For example, the prerequisite judging unit 110 may determine at least one prerequisite corresponding to the diagnostic content by referring to a pre-stored list of prerequisites.

The prerequisite information obtaining step (S200) is a step of obtaining prerequisite information corresponding to the prerequisite from an external device 200, and may be performed by the prerequisite judging unit 110.

For example, the prerequisite judging unit 110 may obtain prerequisite information from the external device 200 to verify the determined prerequisite.

The prerequisite satisfaction determining step (S300) is a step of determining whether the prerequisite is satisfied based on the obtained prerequisite information, and may be performed by the prerequisite judging unit 110.

For example, specifically, the prerequisite judging unit 110 may determine whether the prerequisite corresponding to the diagnostic content is satisfied by substituting the obtained prerequisite information into the corresponding prerequisite.

The battery information obtaining step (S400) is a step of obtaining battery information corresponding to the diagnostic content, and may be performed by the state diagnosing unit 120.

For example, the state diagnosing unit 120 may be configured to obtain battery information corresponding to the diagnostic content. Preferably, the state diagnosing unit 120 may obtain information about diagnostic target factors included in the diagnostic content.

The battery state diagnosing step (S500) is a step of diagnosing the state of the battery based on the diagnostic content and the battery information depending on whether the prerequisite is satisfied, and may be performed by the state diagnosing unit 120.

For example, the state diagnosing unit 120 may diagnose the state of the battery by substituting the obtained battery information into the diagnostic content.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

1: vehicle
10: battery pack
11: battery
12: measuring unit
100: apparatus for diagnosing a battery
110: prerequisite judging unit
120: state diagnosing unit
130: storage unit

## Claims

1. An apparatus for diagnosing a battery, comprising:
a prerequisite judging unit configured to determine a prerequisite preset to correspond to a diagnostic content for a battery, obtain prerequisite information corresponding to the prerequisite from an external device, and determine whether the prerequisite is satisfied based on the obtained prerequisite information; and
a state diagnosing unit configured to obtain battery information corresponding to the diagnostic content and diagnose the state of the battery based on the diagnostic content and the battery information depending on whether the prerequisite is satisfied.

2. The apparatus for diagnosing a battery according to claim 1,
wherein when the prerequisite is satisfied, the state diagnosing unit is configured to diagnose the state of the battery by comparing the battery information corresponding to the diagnostic content with the diagnostic content.

3. The apparatus for diagnosing a battery according to claim 1,
wherein when the prerequisite is not satisfied, the state diagnosing unit is configured to assume that the prerequisite is satisfied and diagnose an expected state of the battery by comparing the battery information corresponding to the diagnostic content with the diagnostic content.

4. The apparatus for diagnosing a battery according to claim 3,
wherein when the prerequisite is plural, the state diagnosing unit is configured to diagnose an expected state of the battery if any one of the plurality of prerequisites is not satisfied.

5. The apparatus for diagnosing a battery according to claim 1, further comprising:
a storage unit configured to store at least one diagnostic content for the state of the battery and at least one prerequisite corresponding to the diagnostic content.

6. The apparatus for diagnosing a battery according to claim 5,
wherein the state diagnosing unit is configured to store the diagnosis result for the battery, a diagnosis type indicating the state of the battery, and whether the prerequisite is satisfied in the storage unit.

7. The apparatus for diagnosing a battery according to claim 6,
wherein the state diagnosing unit is configured to determine a DTC flag indicating the diagnosis result for the battery, a diagnosis type flag indicating the diagnosis type, and a prerequisite flag indicating whether the prerequisite is satisfied, and map and store the DTC flag, the diagnosis type flag, and the prerequisite flag in the storage unit.

8. The apparatus for diagnosing a battery according to claim 7,
wherein when the prerequisite is plural, the state diagnosing unit is configured to determine the prerequisite flag for each of the plurality of prerequisites.

9. A battery pack, comprising the apparatus for diagnosing a battery according to any one of claims 1 to 8.

10. A vehicle, comprising the apparatus for diagnosing a battery according to any one of claims 1 to 8.

11. A method for diagnosing a battery, comprising:
a prerequisite determining step of determining a prerequisite preset to correspond to a diagnostic content for a battery;
a prerequisite information obtaining step of obtaining prerequisite information corresponding to the prerequisite from an external device;
a prerequisite satisfaction determining step of determining whether the prerequisite is satisfied based on the obtained prerequisite information;
a battery information obtaining step of obtaining battery information corresponding to the diagnostic content; and
a battery state diagnosing step of diagnosing the state of the battery based on the diagnostic content and the battery information depending on whether the prerequisite is satisfied.
